# FASCICULE DE BREVET EUROPEEN

(11) **EP 3 840 019 B1**
(45) Date de publication et mention de la délivrance du brevet: **27.07.2022**
(21) Numéro de dépôt: 20214516.5
(22) Date de dépôt: 16.12.2020
(51) Int. Cl.: H01L 21/322, H01L 21/265, H01L 21/268, G01N 27/12, H01L 31/0236

(54) **PROCÉDÉ DE FORMATION D'UNE PORTION POREUSE DANS UN SUBSTRAT**
VERFAHREN ZUR HERSTELLUNG EINES PORÖSEN TEILS IN EINEM SUBSTRAT
METHOD FOR FORMING A POROUS PORTION IN A SUBSTRATE

(30) Priorité: 19.12.2019 FR 1915021
(43) Date de publication de la demande: 23.06.2021
(73) Titulaire: Commissariat à l'Energie Atomique et aux Energies Alternatives, 75015 Paris (FR)
(72) Inventeur: REBOH, Shay, 38054 GRENOBLE CEDEX 09 (FR); ACOSTA ALBA, Pablo, 38054 GRENOBLE CEDEX 09 (FR)
(74) Mandataire: Hautier IP

(56) Documents cités:
- WO-A2-2011/066035
- CHRISTIAN SÄMANN ET AL: "Pulsed Laser Porosification of Silicon Thin Films", MATERIALS, vol. 9, no. 7, 18 juin 1016 (1016-06-18), page 509, XP055728610, CH ISSN: 1996-1944, DOI: 10.3390/ma9070509

## Description

### DOMAINE TECHNIQUE

La présente invention concerne le domaine des procédés de modification de surface de substrat, et plus particulièrement des procédés de formation de matériau poreux. Elle peut trouver pour application particulièrement avantageuse la formation de silicium noir, par exemple pour le photovoltaïque. D'une manière générale, le domaine des dispositifs micro-électroniques est visé. Par dispositif microélectronique, on entend tout type de dispositif réalisé avec les moyens de la microélectronique. Ces dispositifs englobent notamment en plus des dispositifs à finalité purement électronique, des dispositifs micromécaniques ou électromécaniques (MEMS, de l'anglais *microelectromechanical systems* que l'on peut traduire par systèmes microélectromécaniques, NEMS, de l'anglais *nanoelectromechanical systems* que l'on peut traduire par systèmes nanoélectromécaniques,...) ainsi que des dispositifs optiques ou optoélectroniques (MOEMS, de l'anglais *Micro-Opto-Electro-Mechanical System* que l'on peut traduire par microsystèmes opto-électromécaniques, ...).

### ETAT DE LA TECHNIQUE

Les matériaux poreux font aujourd'hui l'objet de nombreuses recherches pour diverses applications. Par exemple, ces matériaux permettent d'augmenter la sensibilité de certaines analyses chimiques, et notamment dans des capteurs de gaz, grâce au rapport élevé de leur surface spécifique sur leur volume. La porosité de ces matériaux induit par ailleurs une diminution de leur conductivité thermique, ce qui est particulièrement avantageux pour des applications de conversion d'énergie par thermoélectricité. Parmi les matériaux poreux, et plus particulièrement les matériaux semi-conducteurs poreux, le silicium poreux est étudié comme matériau anodique dans les batteries lithium-ion à haute densité énergétique. En effet, il est connu que le silicium peut se dilater jusqu'à 270 % pendant l'insertion de lithium, ce qui peut entrainer une fracture mécanique du silicium. Lorsque le silicium est poreux, sa stabilité au cours des cycliques charge-décharge de la batterie est augmentée, la porosité facilitant l'expansion du silicium.

Le silicium poreux est généralement produit par gravure chimique humide de plaquettes, communément appelées wafers, de silicium cristallin. Parmi les procédés de gravure chimique humide, un procédé courant est la gravure anodique, dans lequel un wafer de silicium, connecté à une électrode positive, est immergé dans une solution aqueuse d'acide fluorhydrique. Ce procédé permet une dissolution du silicium pour créer une structure poreuse homogène. Les pores produits sont formés sur plusieurs microns de profondeur, avec des diamètres compris entre quelques nanomètres à quelques micromètres.

Dans un autre procédé de gravure chimique humide, la surface d'un wafer de silicium est couverte d'une fine couche de métal, par exemple d'une épaisseur inférieure à 10 nanomètre (nm), afin de faciliter la gravure du silicium par une solution aqueuse d'acide fluorhydrique et de peroxyde d'hydrogène. Selon le métal et le dopage du silicium, des réactions locales d'oxydoréduction se produisent et permettent d'obtenir différentes porosités en utilisant des taux de gravure différents.

D'autres procédés de gravure chimique humide utilisent de l'acide fluorhydrique et un oxydant chimique en faible quantité, tel que de l'acide nitrique ou du trioxyde de chrome pour produire des films poreux superficiels sur le wafer de silicium. Toutefois, l'épaisseur des films poreux produits est limitée à 100 nm d'épaisseur.

Les procédés énoncés précédemment mettent en œuvre des bains d'acide fluorhydrique, un composé très corrosif et toxique, et demandent un rinçage important, ce qui implique le traitement d'un volume important d'effluent dangereux pour l'environnement et la santé. En outre, les procédés de gravure chimique humide sont de façon générale isotropes, ce qui limite la diversité de structures poreuses qu'il est possible d'obtenir.

Le document C. Sämann, et al., *Pulsed Laser Porosification of Silicon Thin Films,* Materials, 9, 7, 509, 2016, décrit un procédé physique de formation d'une couche de silicium poreux. Ce procédé comprend un dépôt par pulvérisation d'une couche de silicium amorphe, cette couche comprenant de l'argon provenant du gaz de pulvérisation. De façon alternative, un dépôt chimique en phase vapeur assisté par plasma d'une couche de silicium amorphe peut être réalisé, cette couche comprenant alors de l'hydrogène provenant du précurseur silane. La couche de silicium déposée est ensuite exposée à un laser pulsé, de sorte que le silicium passe de l'état solide à l'état liquide, induisant ainsi l'élimination des bulles de gaz d'argon ou de dihydrogène, et se solidifie en formant une couche mince de silicium poreux.

Dans ce procédé, les gaz sont incorporés à la couche de silicium lors de son dépôt. Les gaz sont donc incorporés dans l'ensemble de la couche de silicium déposée. En outre, les structures poreuses qu'il est possible d'obtenir par ce procédé restent limitées.

WO 2011/066035 A2 (IBM [US]; BOTULA ALAN B [US] ET AL.) 3 juin 2011 (2011-06-03) décrit un procédé de formation d'une portion poreuse dans un substrat.

Un objet de la présente invention est donc de proposer un procédé amélioré de formation d'une portion poreuse dans un substrat. Notamment, un objet non limitatif de la présente invention est de proposer un procédé permettant la formation de structures poreuses diverses dans un substrat.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation, on prévoit un procédé de formation d'une portion poreuse dans un substrat, le procédé comprenant :
- une fourniture d'un substrat comprenant une couche,
- une implantation d'ions choisis parmi des ions d'hydrogène et de gaz noble dans au moins une zone de la couche, la zone implantée étant située à une profondeur d'implantation dans la couche, de façon à former au moins une portion enrichie en au moins un gaz dans la zone implantée, puis
- un recuit par laser de type nanoseconde de sorte à induire, à partir de la zone implantée, au moins l'un parmi la formation et le développement d'une portion poreuse dans le substrat.

De préférence, la couche poreuse s'étend depuis la surface du substrat. L'utilisation de l'implantation d'ions permet de dissocier le dépôt de la couche, de l'incorporation de gaz. Ceci présente plusieurs avantages. L'implantation d'ions peut être utilisée pour introduire des ions de gaz dans tout type de matériau, et notamment dans un matériau semi-conducteur, y compris pour des semi-conducteurs cristallins, voire monocristallins, ou un matériau diélectrique.

La nature des éléments chimiques des ions implantés n'est en outre pas limitée à des ions issus de, ou compatibles avec, un procédé de dépôt de la couche. Une grande variété de molécules de gaz, voire un mélange de ces gaz peut ainsi être incorporé dans la couche. La distribution de taille des pores formés dépendant de la nature du gaz implanté, le procédé permet d'ajuster la porosité de la couche dans une gamme de taille de pores plus étendue que l'état de la technique.

En outre, selon les paramètres de l'implantation d'ions, la profondeur d'implantation dans la couche peut être ajustée, et notamment selon la nature chimique des ions, l'énergie d'implantation et la nature du matériau de la couche.

On comprend donc qu'une grande variété de structures poreuses peut être obtenue par le procédé. Ces structures poreuses peuvent être adaptées pour de nombreuses applications selon les propriétés recherchées. En outre, ce procédé est entièrement compatible avec la plupart des technologies et procédés d'intégration, notamment en micro et nanofabrication, et en particulier avec les procédés d'élaboration de dispositif comprenant un substrat, par exemple en un matériau semi-conducteur.

La portion poreuse peut s'étendre de la zone implantée à la surface exposée du substrat. De préférence, la couche est en surface du substrat, et la portion poreuse est formée dans une portion de la couche, de la zone implantée jusqu'à une surface exposée de la couche.

De manière facultative, le procédé peut en outre comprendre l'application d'un masque sur une fraction d'une surface exposée du substrat, préalablement à l'implantation d'ions. Le procédé peut en outre comprendre un retrait du masque après l'implantation d'ions. Selon un exemple, le retrait du masque est effectué entre l'implantation d'ions et le recuit par laser. Grâce à l'application d'un masque, l'implantation d'ions peut être réalisée à une profondeur donnée et dans au moins une fraction de la couche. La portion poreuse formée dans la couche est ainsi localisée, voire fractionnée ou de façon équivalente discontinue, dans un plan d'extension principale de la couche. Le procédé selon cette caractéristique permet d'augmenter encore la variété de structures poreuses qu'il est possible d'obtenir.

Un autre aspect est un composant micro-électronique comportant au moins une portion poreuse.

### BREVE DESCRIPTION DES FIGURES

Les buts, objets, ainsi que les caractéristiques et avantages de l'invention ressortiront mieux de la description détaillée de plusieurs modes de réalisation de cette dernière, illustrés par les dessins d'accompagnement suivants.
La figure 1 représente une vue schématique et selon une section transversale de la couche d'un substrat mis en œuvre dans le procédé selon un mode de réalisation.
Les figures 2A à 2F illustrent l'implantation d'ions, selon plusieurs modes de réalisation du procédé selon l'invention, dans une portion de la couche illustrée en figure 1.
La figure 3 illustre un recuit thermique selon un mode de réalisation du procédé selon l'invention, réalisé sur la couche, après l'implantation d'ions illustrée en figure 2A.
Les figures 4A à 4E illustrent le recuit par laser, selon plusieurs modes de réalisation du procédé selon l'invention, réalisé sur une couche, après les implantations d'ions illustrées par les figures 2A à 2D et 2F.
La figure 5 représente un graphique de l'évolution du bruit de fond diffus (H, de l'anglais Haze que l'on peut traduire par diffus) en fonction de la fluence (F, en J/cm²) du recuit par laser, pour une portion de silicium poreuse selon un mode de réalisation particulier de l'invention.
Les figures 6A à 6E représentent une vue du dessus en microscopie électronique à balayage de différentes portions poreuses d'une couche, obtenues selon plusieurs modes de réalisation du procédé selon l'invention.
La figure 7 représente un graphique de la réflectivité à un angle d'incidence de 7°, en fonction de la longueur d'onde de la lumière incidente, mesurée pour différents substrats de référence, et différentes portions poreuses obtenues selon plusieurs modes de réalisation particuliers de l'invention.
La figure 8 représente un graphique de la réflectivité mesurée selon plusieurs angles d'incidence, pour une portion de silicium poreuse selon un mode de réalisation particulier de l'invention illustré en figure 7.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs et les dimensions relatives de substrat, de couche, de zone ou des portions illustrés ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
- la profondeur d'implantation peut être inférieure à l'épaisseur totale de la couche,
- la zone implantée peut présenter une épaisseur inférieure à l'épaisseur de la couche,
- lors de l'implantation d'ions, un mélange d'ions d'éléments chimiques distincts peut être implanté de façon à former l'au moins une portion enrichie en une pluralité de gaz. La nature du gaz implanté est un des paramètres permettent de moduler le diamètre et densité des pores de la portion poreuse obtenue,
- lors de l'implantation d'ions, les ions peuvent être des ions choisis parmi des ions d'hydrogène et des ions de gaz noble, les ions de gaz noble étant choisis parmi les ions de l'hélium, du néon, de l'argon et du xénon,
- lors de l'implantation d'ions, les ions peuvent être des ions choisis parmi des ions d'hydrogène et des ions d'hélium,
- l'implantation d'ions peut être réalisée à une température comprise entre -200°C et 1200°C, de préférence entre 20 °C et 450 °C. Selon la température de l'implantation d'ions, les caractéristiques de la portion poreuse obtenue peuvent être modulées, et notamment le diamètre et densité des pores formés peuvent notamment être modulés,
- le procédé peut en outre comprendre un recuit thermique entre l'implantation d'ions et le recuit par laser, de préférence le recuit thermique est réalisé à une température supérieure à la température de l'implantation d'ions, de préférence la température du recuit thermique est comprise entre 200°C et 1200°C, de préférence entre 350°C et 1100°C. Le recuit thermique permet notamment de modifier la portion poreuse obtenue par le procédé,
- le procédé comprend plusieurs implantations d'ions, de préférence successives. Selon un exemple, au moins une implantation d'ions, parmi les implantations d'ions successives, peut être configurée pour implanter un mélange d'ions d'éléments chimiques distincts.
- le procédé peut comprendre plusieurs implantations d'ions, dans lesquelles les éléments chimiques des ions et/ou leurs proportions relatives entre des ions d'éléments chimiques distincts varient entre les différentes implantations d'ions. Ainsi, les ions implantés peuvent être des ions d'éléments chimiques différents. Par exemple, des ions d'hydrogène sont implantés dans une implantation, et des ions d'hélium sont implantés dans une autre implantation. Dans le cas de l'implantation d'un mélange d'ions, les proportions relatives entre les différents ions du mélange peuvent varier entre plusieurs implantations. De façon alternative ou complémentaire, dans au moins une implantation, un seul type d'ion peut être implanté, et dans au moins une autre implantation, un mélange d'ions peut être implanté. De façon alternative ou complémentaire, plusieurs mélanges d'ions peuvent être implantés, les mélanges variant entre les différentes implantations, par exemple par les éléments chimiques des ions, voire leurs proportions relatives entre des ions d'éléments chimiques distincts,
- au moins une parmi les plusieurs implantations d'ions peut être réalisée à une profondeur d'implantation différente par rapport aux profondeurs d'implantation des autres implantations d'ions. De façon synergique, l'implantation de différents ions ou de différents mélanges d'ions, à des profondeurs différentes dans la couche, permet de notamment former une portion poreuse présentant un gradient de porosité,
- au moins une parmi les plusieurs implantations d'ions est configurée pour implanter une dose différente par rapport aux doses implantées des autres implantations d'ions. Selon un exemple, des ions de même élément chimique sont implantés, la dose implantée variant entre les différentes implantations,
- le recuit par laser de type nanoseconde peut être mis en œuvre à une densité d'énergie prédéterminée, la densité d'énergie prédéterminée étant choisie à l'aide d'une courbe représentant, en fonction de la densité d'énergie, un signal proportionnel à une rugosité de la portion poreuse obtenue, et de préférence une rugosité de surface, la courbe présentant au moins une augmentation dudit signal pour une gamme de densité d'énergie, la densité d'énergie prédéterminée étant choisie dans cette gamme. L'augmentation dudit signal peut plus particulièrement être induite par la formation de la portion poreuse
- le recuit par laser peut être effectué à une longueur d'onde comprise entre 200 nm et 400 nm,
- le recuit par laser peut comprendre des impulsions laser présentant une durée comprise entre 1 ns et 1000 ns,
- la couche peut être à base d'un matériau semi-conducteur, de préférence le matériau semi-conducteur est cristallin, voire monocristallin,
- le matériau semi-conducteur peut être à base de silicium monocristallin,
- lorsque le substrat est à base de silicium monocristallin, l'implantation d'ions choisis parmi des ions d'hydrogène et des ions d'hélium est effectuée à une énergie d'implantation comprise entre 30 et 40 keV et pour une dose implantée entre 1.10¹⁶ et 5.10¹⁶ atomes/cm², et dans lequel le recuit par laser est effectué à une fluence supérieure à 3 J/cm²,
- lorsque le substrat est à base de silicium monocristallin, l'implantation d'ions d'hélium peut être effectuée à une énergie d'implantation comprise entre 30 et 40 keV et pour une dose implantée de 4.10¹⁶ atomes/cm², et le recuit par laser peut être effectué à une fluence supérieure à 3 J/cm².

Le procédé comprend les caractéristiques suivantes :
- la portion poreuse comprend des pores présentant une surface interne, comme il découle clairement et sans ambiguïté de la description ci-après,
- le procédé comprend une oxydation thermique de la surface interne des pores de la portion poreuse, comme il découle clairement et sans ambiguïté de la description ci-après,
- le procédé comprend un dépôt d'un matériau diélectrique ou d'un matériau semi-conducteur, sur ladite surface interne, comme il découle clairement et sans ambiguïté de la description ci-après.

On entend par un paramètre « sensiblement égal/supérieur/inférieur à » une valeur donnée, que ce paramètre est égal/supérieur/inférieur à la valeur donnée, à plus ou moins 10 % près, voire à plus ou moins 5 % près, de cette valeur.

Dans la description qui suit, les épaisseurs de couche, de zone ou de portion ainsi que les profondeurs sont généralement mesurées selon une direction verticale, parallèle à la direction d'empilement et perpendiculaire au plan principal d'extension du substrat, de la couche, de la sous-couche ou de la portion.

On entend par un substrat, une couche, une zone ou une portion « à base » d'un matériau A, un substrat, une couche, une zone ou une portion comprenant ce matériau A. Le matériau A peut-être constituée d'un seul élément chimique ou plusieurs éléments chimiques.

Par « portion enrichie » on comprend que la portion comprend comme élément supplémentaire l'au moins un gaz issu des ions implantés.

Par porosité d'une couche, d'une sous-couche, d'une zone ou d'une portion, on entend la proportion de volume des pores par unité de volume dans la couche, la sous-couche, la zone ou la portion.

De manière générale et de façon connue pour l'homme du métier, par porosité ouverte, on désigne la porosité d'un substrat ou d'une couche en communication avec l'environnement du substrat ou de la couche, les pores étant interconnectés entre eux. Dans le cadre de l'invention, les énergies sont données en électronvolt, pour lequel 1 eV ≈ 1,602.10⁻¹⁹ J, dans le système international des unités.

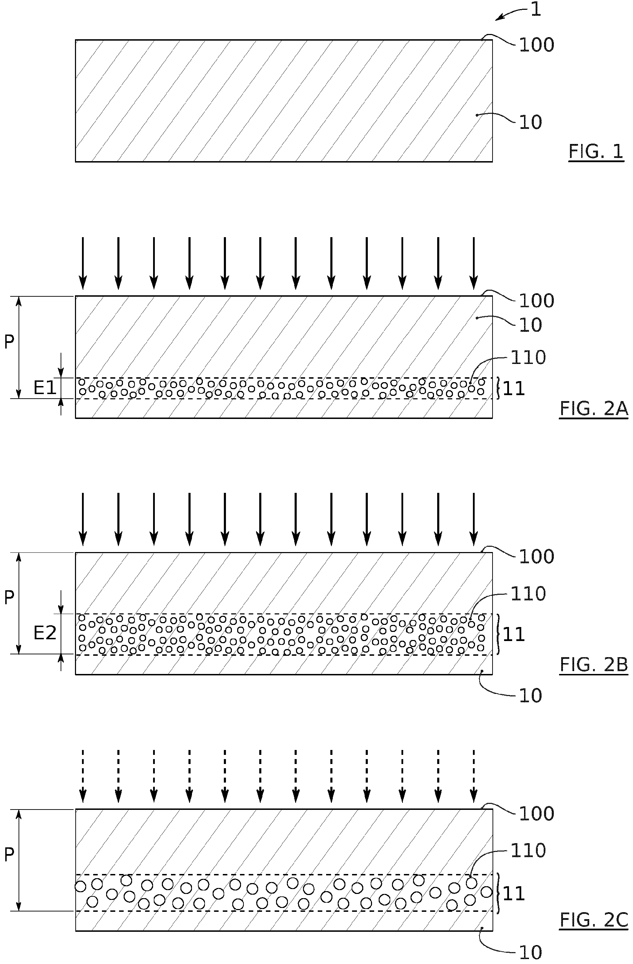

Le procédé est maintenant décrit en référence aux figures 1 à 4E. Le procédé comprend tout d'abord la fourniture d'un substrat 1, comme illustré en figure 1. Ce substrat 1 comprend une couche 10. Notons que sur les figures, seule la couche 10 du substrat 1 est représentée. Le substrat 1 peut néanmoins être sous la forme d'un empilement d'une pluralité de couches, par exemple à base de différents matériaux. Le substrat 1 peut par exemple comprendre la couche 10 et une couche d'oxyde de surface, et notamment une couche mince. Selon un exemple alternatif ou complémentaire, le substrat 1 comprend une couche d'un semi-conducteur dopé, et d'un semi-conducteur non dopé, la couche 10 pouvant être l'une et/ou l'autre de ces couches. Selon un autre exemple, la couche 10 peut être située en surface du substrat 1 et présenter une surface exposée 100.

La couche 10 peut plus particulièrement être à base d'un matériau semi-conducteur, ou un matériau diélectrique, ou un matériau métallique. Le matériau diélectrique peut être un oxyde, et notamment d'un oxyde de semi-conducteur, par exemple un oxyde de silicium, et/ou être à base de tout semi-conducteur, et par exemple à base de silicium, de germanium, d'arséniure de gallium ou de carbure de silicium, de nitrure de gallium et de phosphure d'indium. Le matériau semi-conducteur est de préférence cristallin, voire monocristallin. La couche 10 peut en outre être uniquement constituée du matériau semi-conducteur, en négligeant les impuretés liées à la l'élaboration du semi-conducteur. Dans la suite de la description, on se réfère de façon non-limitative à l'exemple dans lequel la couche 10 est située en surface du substrat 1 et dans lequel la couche 10 est à base d'un matériau semi-conducteur.

L'implantation d'ions est décrite en référence aux figures 2A à 2E. L'implantation d'ions est mise en œuvre sur le substrat 1 de façon à implanter des ions dans une zone 11 de la couche 10 de façon localisée selon une direction perpendiculaire à un plan principal d'extension de la couche 10. Cette zone 11 s'étend plus particulièrement parallèlement au plan principal d'extension de la couche 10. L'implantation d'ions est en outre configurée de sorte que la plus forte concentration d'ions implantée, appelée zone implantée 11 se situe à une profondeur P depuis la surface exposée 100, ici de la couche 10, ou du substrat 1 ou de l'empilement selon le cas. Pour cela, la couche 10 est soumise à un flux d'ions à une énergie d'implantation et de façon à implanter une dose d'ions dans la couche 10. Notons que sur les figures, la profondeur P est définie comme la profondeur jusqu'à laquelle s'étend la zone implantée 11. La profondeur P peut de façon alternative être définie jusqu'à un plan médian de la zone implantée 11, ce plan médian étant parallèle au plan d'extension principale de la couche 10.

L'implantation d'ions induit ainsi la formation d'une portion enrichie en au moins un gaz au niveau de la zone implantée 11. Cette portion enrichie en gaz peut être sous la forme d'une microstructure de bulles 110, les bulles se référant à une pluralité de volumes fermés dans le matériau, ces volumes comprenant de préférence l'au moins un gaz. En alternative, la portion enrichie en gaz peut ne pas être sous la forme de bulles suite à l'étape d'implantation, par exemple le gaz est diffus dans cette couche. Les bulles 110 pourront notamment être formées lors d'un recuit, décrit plus en détail ultérieurement. Dans la suite, on désigne le terme générique de microstructure 110 pour désigner ces différents modes de la portion enrichie en gaz.

Selon des paramètres de l'implantation d'ions, les bulles 110 présenteront différentes morphologies et différentes distributions de taille et densité de bulles. Les paramètres de l'implantation d'ions comprennent principalement la nature chimique des ions implantés, et notamment l'élément chimique des ions implantés, la température d'implantation et plus particulièrement la température du substrat 1 lors de l'implantation, le courant d'implantation, l'énergie d'implantation et la dose implantée. Notons que des outils de calculs d'arrêt et portée des ions dans la matière (pouvant être abrégé SRIM, de l'anglais *Stopping and Range* of *Ions in Matter*) peuvent être utilisés pour déterminer la pénétration des ions dans la matière. Notons en outre que pour un type d'ion implanté, une énergie d'implantation et une dose implantée, la nature chimique du semi-conducteur peut en outre influer sur la microstructure 110 formée.

L'énergie d'implantation influe notamment sur la profondeur P de la portion enrichie en gaz. L'énergie d'implantation peut plus particulièrement être comprise entre 0,5 keV et 1 MeV et de préférence entre 0,5 et 200 keV. L'implantation d'ions peut plus particulièrement être réalisée à une température comprise entre sensiblement -200 °C, correspondant à la température de l'azote liquide, et 1200 °C. L'implantation d'ions peut plus particulièrement être réalisée à une température comprise entre 20°C et 450°C. La dose d'ions implantés peut être comprise entre 10¹⁵ et 10¹⁸ ions/cm².

Selon un premier exemple illustré en figure 2A, des ions sont implantés dans la couche 10 à travers sa surface 100, comme représenté par les flèches, au niveau d'une zone 11, à une profondeur P et sur une épaisseur E₁. Selon un exemple, la zone implantée 11 peut s'étendre de la profondeur P à la surface 100 de la couche 10, voire du substrat 1.

L'épaisseur de la zone 11 implantée peut être augmentée, comme illustré par exemple illustré dans la figure 2B, en augmentant la dose implantée et/ou en effectuant de multiples implantations, par exemple à des énergies d'implantation différentes. Pour une implantation effectuée à une première énergie, la ou les implantations suivantes peuvent être réalisées à des énergies inférieures et/ou supérieures telles que les profils de distribution des ions implantés se chevauchent d'au moins 10% de la dose implantée.

Des ions de natures chimiques distinctes, et plus particulièrement d'éléments chimiques distincts peuvent par ailleurs être implantés, voire un mélange d'ions de natures chimiques distinctes peut être implanté. Le procédé permet ainsi l'incorporation de différents gaz, voire d'un mélange de gaz dans la portion enrichie 11. En fonction de la nature du gaz, la microstructure 110, par exemple le diamètre des bulles, peut varier. Les ions peuvent être choisis parmi les ions de l'hydrogène, et/ ou les ions de gaz noble. ou de façon équivalente de gaz rare. Les ions de gaz noble sont choisis parmi les ions, de l'hélium, du néon, de l'argon, du krypton, du xénon et du radon. De préférence, des ions d'hélium, d'argon, de néon, de xénon, ou leur mélange peuvent être implantés.

Selon un troisième exemple, illustré dans la figure 2C, des ions sont implantés à une profondeur P dans la couche 10, comme représenté par les flèches en pointillés, ces ions étant d'éléments chimiques distincts par rapport aux ions implantés dans le premier exemple illustré par la figure 2A. Cette différence d'élément chimique peut notamment influer sur la morphologie de la zone implantée 11. Par exemple, les bulles 110 peuvent avoir un diamètre supérieur à celui des bulles 110 formées dans le premier exemple.

Notons que dans les exemples précédemment décrits, les profondeurs P peuvent varier d'un exemple à un autre, et par exemple selon l'énergie d'implantation utilisée.

En outre, le procédé peut comprendre plusieurs implantations d'ions, de préférence successives. Ces implantations d'ions peuvent être configurées de façon à former des microstructures en plusieurs zones 11 dans la couche 10. Ces zones pouvant être en contact entre elles selon une direction perpendiculaire à un plan principal d'extension de la zone implantée 11. Des microstructures en plusieurs zones 11 peuvent ainsi être formées. Ces microstructures peuvent présenter différentes morphologies et différentes distributions de taille et densité de bulles selon les paramètres d'implantation.

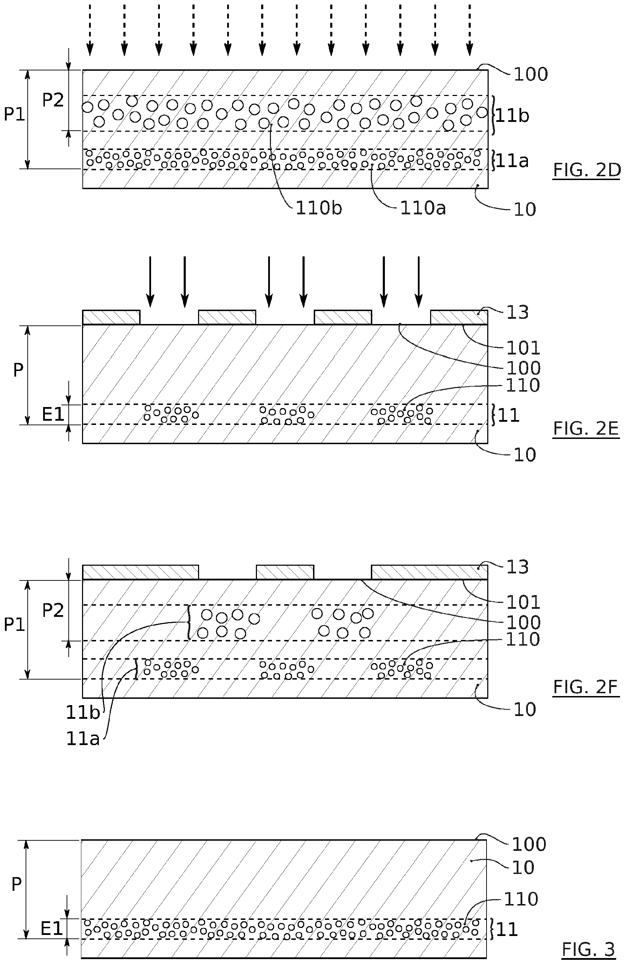

À titre d'exemple, une première implantation d'ions peut être effectuée. Comme illustré en figure 2D, une première microstructure 110a peut être obtenue dans une zone implantée 11a, à une profondeur P₁ de la couche 10. À la suite de cette première implantation, une deuxième implantation d'ions et configurée de façon à obtenir une deuxième microstructure 110b, dans une zone implantée 11b à une profondeur P₂ de la couche 10, et présentant une morphologie distincte de la première microstructure 100a. Selon l'exemple illustré, la deuxième implantation peut être réalisée à une deuxième dose plus élevée que celle de la première implantation. De façon alternative ou complémentaire, la température d'implantation lors de la première ou deuxième implantation peut être modifiée de façon à changer la microstructure 110b. La nature des ions implantés dans chaque zone 11 peut de façon alternative ou complémentaire être modifiée. Dans une zone implantée 11b, on peut former des bulles 110b d'un diamètre distinct, à celui des bulles d'une zone implantée plus éloignée de la surface 100 de la couche 10, en suivant une direction perpendiculaire à la direction d'extension principale du substrat. Selon l'exemple illustré en figure 2D, le diamètre des bulles 110b est supérieur à celui des bulles 110a d'une zone implantée plus éloignée de la surface 100 de la couche 10. On peut prévoir que le diamètre des bulles 110b est inférieur à celui des bulles 110a d'une zone implantée plus éloignée de la surface 100 de la couche 10, l'implantation de la première zone 11a étant par exemple réalisée à une température d'implantation plus élevée que l'implantation de la deuxième zone 11b.

Le procédé peut en outre comprendre l'application d'un masque 13 sur une fraction 101 de la surface 100 de la couche 10, pour former une ou plusieurs zones 11 implantées. Comme illustré en figure 2E, la zone implantée peut notamment être fractionnée, ou de façon équivalente discontinue, dans le plan d'extension principale de la couche 10. Les paramètres de l'implantation d'ions peuvent être modifiés comme énoncés précédemment. Le masque peut être configuré de sorte que seule la fraction non masquée de la surface 100 soit exposée au/aux flux d'ions lors de l'implantation. Ainsi la zone implantée 11, voire la pluralité de zones 11 implantées, peut s'étendre dans le plan d'extension principale de la couche 10, à une profondeur P, en regard de la fraction non masquée de la surface 100. Selon un exemple, un masque 13, à base de nitrure de silicium, peut être utilisé. Suite à la ou les implantations d'ions, le masque 13 peut être retiré. Dans un mode de réalisation particulier, le masque 13 est retiré à la suite de la ou les implantations d'ions et avant que des recuits thermiques ou des recuits par laser soient effectués sur le substrat 1.

Le procédé pouvant comprendre plusieurs implantations d'ions, le procédé peut en outre comprendre plusieurs applications et plusieurs retraits d'un masque 13, par exemple pour chacune des implantations d'ions. Les paramètres de l'implantation d'ions peuvent être modifiés entre les différentes implantations d'ions. Des zones 11a, 11b implantées de façon fractionnée peuvent ainsi être formées à plusieurs profondeurs P₁ et P₂ de la couche 10, comme illustré en figure 2F. Les zones 11a, 11b implantées peuvent en outre présenter des microstructures 110a, 110b différentes.

Le procédé peut comprendre un recuit thermique du substrat 1, de façon à modifier la microstructure formée par implantation. Ce recuit thermique peut être effectué à la suite d'une implantation ou d'une pluralité d'implantations. En outre, le recuit peut être effectué entre plusieurs implantations. Ce recuit thermique peut être configuré pour former la microstructure de bulles 110 à partir de la portion enrichie en gaz, ou modifier la morphologie des bulles 100 préalablement formées. Notamment, un recuit thermique de la couche 10 du substrat 1 peut entraîner un grossissement des bulles 110, selon l'exemple illustré par le passage de la figure 2A à la figure 3. Pour cela, le recuit thermique peut être réalisé à une température comprise entre 200°C et 1200°C, notamment à une température supérieure à une température de l'implantation d'ions. De préférence, la température du recuit thermique est comprise entre 350°C et 1100°C. À titre d'exemple, le diamètre de bulles de néon implantées à 250 °C, pour une dose implantée de l'ordre de 10¹⁶ atomes/cm², et à la suite d'un recuit thermique de 5 heures à 1100°C, peut augmenter jusqu'à 200 nm, comme décrit dans le document Caracterização da implantação de Ne em Si (100), Suzana Bottega Peripolli, Université Fédérale de Rio Grande do Sul, 2007.

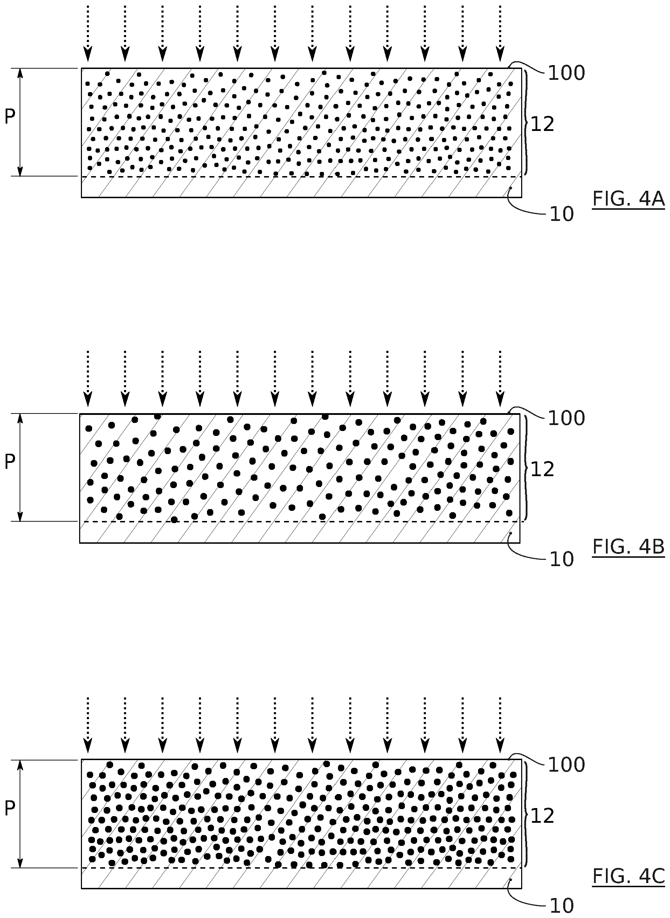

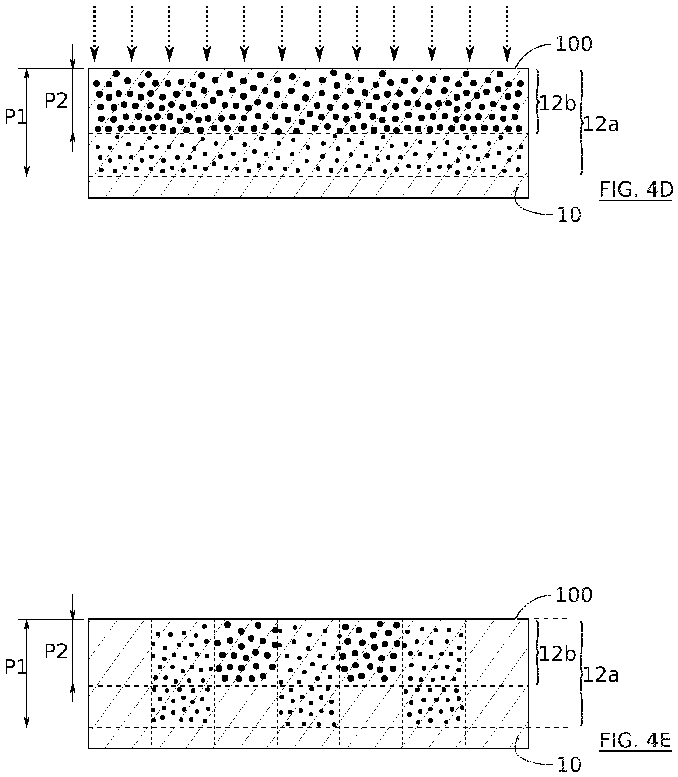

Suite à l'implantation d'ions, voire suite à un éventuel recuit thermique, le procédé comprend ensuite un recuit par laser du substrat 1. Le recuit laser est maintenant décrit en référence aux figures 4A à 4E. Ce recuit est dit pulsé, c'est-à-dire que la surface exposée 100 de la couche 10 est soumise à un rayonnement laser de façon intermittente par au moins une impulsion laser ou plusieurs impulsions. L'exposition au rayonnement laser induit une fusion du matériau semi-conducteur au moins dans une portion 12. Suite à cette exposition au rayonnement laser, l'au moins une portion 12 du matériau semi-conducteur se solidifie en conservant des pores pour obtenir la portion poreuse 12'. Selon l'énergie, la durée et le nombre d'impulsions laser, les caractéristiques de la portion poreuse 12' peuvent être modulées.

La portion 12 s'étend dans la couche 10 à la surface exposée 100 du substrat 1. La portion 12, et donc la portion poreuse 12' correspondante, dépend de la microstructure formée lors de l'implantation, voire suite à un ou plusieurs éventuels recuits thermiques. Plus particulièrement, les caractéristiques de la portion poreuse 12' obtenue peuvent dépendre de la distribution des bulles 110 préalablement formées, et notamment de leur nombre et de leur diamètre, de la profondeur et de l'épaisseur de la microstructure 110. En alternative, le recuit par laser peut induire la formation de bulles 110 à partir de la portion enrichie en gaz, dont les caractéristiques dépendent des paramètres de l'implantation, voire d'un éventuel recuit thermique. Par exemple, à partir des microstructures décrites dans les figures 2A à 2D et 2F, on comprend qu'il se forme les portions de diffusion 12, voir les portions 12a et 12b, et donc les portions poreuses correspondantes, illustrées dans les figures 4A à 4E.

Le recuit par laser pulsé est ici un recuit par laser de type nanoseconde, c'est à dire que la durée des impulsions laser est notamment comprise entre 1 ns (10⁻⁹ secondes) et 1000 ns. L'utilisation d'un recuit par laser de type nanoseconde permet d'une part d'induire la fusion de seulement la portion 12, et d'autre part d'éviter que la durée durant laquelle le matériau semi-conducteur est en fusion ne soit trop longue, et induise un rebouchage des cavités. En outre, un recuit par laser de type nanoseconde permet de limiter, voire d'éviter, une augmentation trop importante de la température du substrat 1. Le risque de dégradation du substrat 1 est donc minimisé, voire évité. De préférence, la durée des impulsions est comprise entre 50 et 250 ns, et plus préférentiellement elle est sensiblement égale à 160 ns.

La longueur d'onde du recuit par laser pulsé est de préférence choisie pour conduire à une forte absorption du rayonnement laser par le matériau. On choisit par exemple un laser de longueur d'onde inférieure à 400 nm dans le cas où la couche 10, voire le substrat 1 est en silicium, en germanium ou en silicium-germanium. De préférence, le recuit par laser est effectué à une longueur d'onde comprise entre 200 nm et 400 nm. Dans le domaine des UV proches, le rayonnement est plus énergétique que dans le visible, et permet une concentration de l'énergie dans une partie superficielle du substrat 1, et notamment au niveau de la couche 10. Ainsi, le risque de détérioration du substrat au-delà de la couche 10, voire au-delà de la zone 11 implantée, est minimisé, voire évité.

La densité d'énergie du recuit par laser, pouvant être désignée fluence F énergétique, peut en outre être choisie de façon à modifier la microstructure de la portion poreuse 12' obtenue, et notamment la porosité et l'état de surface de la portion poreuse 12'. Pour cela, au cours du développement de l'invention, l'influence de la fluence F du recuit par laser a été étudiée sur une couche 10 comprenant une zone 11 implantée selon un mode de réalisation particulier du procédé. Une zone 11 implantée a été formée dans une couche 10 de silicium monocristallin sur plusieurs substrats 1, par implantation d'un mélange d'ions d'hydrogène et d'hélium à une énergie comprise entre 30 et 40 keV, à une dose totale de 2.10¹⁶ ions/cm². Chacun de ces substrats 1 a ensuite été irradié une fluence F comprise entre 0,4 J/cm² et 3,125 J/cm², par pas de 0,025 J/cm².

L'état de surface de chaque substrat 1 peut être évalué au moyen d'une mesure d'un signal proportionnel à la rugosité de cette surface. Ce signal peut être le bruit de fond diffus (H, de l'anglais « Haze » selon la terminologie anglosaxonne communément employée) communément employé par l'homme du métier, correspondant à l'intensité de la lumière diffusée par la surface de la couche. À titre d'exemple, selon la norme ASTM D4039, le bruit de fond diffus peut être défini comme la différence numérique entre la réflexion spéculaire à 60° et celle à 20°. Les mesures de bruit de fond diffus ont été effectuées à l'aide de l'outil d'inspection Surfscan^{®} SP2 de la société KLA-Tencor.

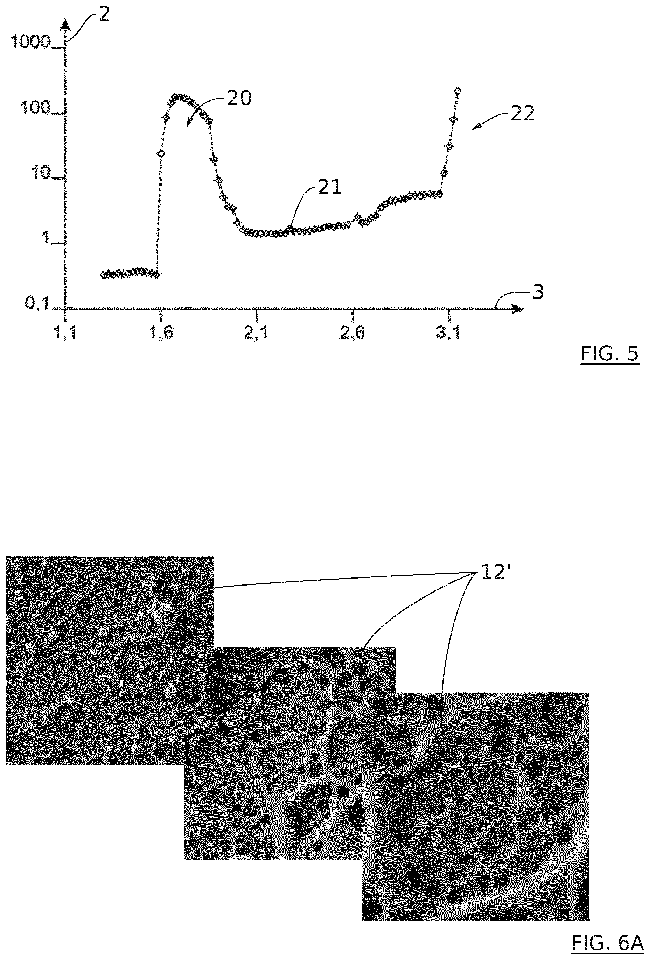

Une courbe d'étalonnage du bruit de fond diffus H en fonction de la fluence F du recuit par laser peut être obtenue. Cette courbe d'étalonnage est décrite dans la suite en référence à la figure 5, pour un substrat de silicium implanté selon les paramètres énoncés précédemment. Cette courbe peut présenter au moins une augmentation du bruit de fond diffus à partir d'une valeur de fluence. Cette augmentation peut s'expliquer par la génération de la portion poreuse provoquant une augmentation de la rugosité de la surface 100. Cette courbe peut donc être utilisée pour donner une indication de la fluence F du recuit laser à utiliser. Notons que la fluence F du recuit laser à utiliser peut varier selon la nature du substrat 1, et par exemple selon le matériau de la couche 10. Notons qu'en alternative ou en complément, une caractérisation par microscopie électronique à balayage ou par transmission peut être effectuée.

Selon l'exemple illustré, cette courbe peut présenter en effet un premier régime 20 de bruit de fond diffus à basse fluence F, en observant un pic d'intensité du bruit de fond diffus pour des fluences F sensiblement comprises entre 1,6 et 1,9 J/cm². Ce pic semble lié à une augmentation de la rugosité de surface du fait de la formation de structures surfaciques. Ces structures surfaciques, constatée en microscopie électronique à balayage, peuvent être associées à un début de fusion localisée de la surface 100 du substrat 1 induisant de la rugosité.

Pour des fluences F supérieures à 2 J/cm², on constate par microscopie électronique à balayage qu'une diminution du bruit de fond diffus est obtenue, dans un deuxième régime intermédiaire 21, pouvant être liée à une fusion et recristallisation homogène du semi-conducteur de la couche 10 faisant suite à une fusion totale de la surface 100 au cours du recuit par laser.

Pour des fluences F supérieures à 3 J/cm², un nouveau pic d'intensité du bruit de fond diffus est observé, au niveau d'un troisième régime 22. On constate un phénomène texturisation de surface par microscopie électronique à balayage. Il a en outre été constaté que lors du développement de l'invention que pour une fluence F élevée, il se forme une porosité ouverte à la surface 100 du substrat 1. De préférence, le traitement par recuit par laser est réalisé à une fluence F choisie dans le troisième régime 22, c'est à dire le régime de haute fluence F, de façon à obtenir une portion poreuse 12' à haut bruit de fond diffus. Selon cet exemple, une fluence F supérieure à 3 J/cm² peut être choisie pour un substrat 1 comprenant une couche 10 de silicium cristallin.

Cette courbe d'étalonnage peut être obtenue pour d'autres paramètres d'implantation dans un substrat à base de silicium, et pour d'autres substrats 1, et notamment pour des couches 10 comprenant d'autres matériaux semi-conducteurs. De préférence, on choisit de se placer dans un régime de haute fluence F, de façon à obtenir une portion poreuse 12' à haut bruit de fond diffus, pour l'ensemble des matériaux semi-conducteurs.

En outre, suite au recuit par laser, le procédé comprend un traitement de surface de la portion poreuse 12', non représenté sur les figures. Notamment, une oxydation thermique de la surface interne de la portion poreuse 12' peut être effectuée. Un matériau diélectrique ou un matériau semi-conducteur peut être déposé sur la surface interne de la portion poreuse 12'. Dans le cas du dépôt d'un matériau semi-conducteur, tel que du silicium ou du germanium, on préférera un dépôt par épitaxie. Pour une fluence F élevée, comme il se forme une porosité ouverte à la surface 100 du substrat 1, un traitement de la surface interne de la portion poreuse 12' au moins une espèce réactive est facilité.

Quelques exemples d'images en microscopie électronique à balayage de portions poreuses 12' obtenues selon plusieurs modes de réalisation du procédé, à partir d'une couche de silicium, sont maintenant décrites en référence aux figures 6A à 6E. Selon un premier exemple, la portion poreuse 12' obtenue pour une implantation d'ions d'hélium à 52 keV, à une dose de 4.10¹⁴ ions/cm², suivi d'un recuit par laser avec une durée d'impulsion de 160 ns, à une fluence F = 3,1 J/cm², est illustrée en figure 6A. Selon cet exemple, on peut plus particulièrement observer la forte texturation de surface obtenue après le recuit par laser dans un régime de haute fluence F.

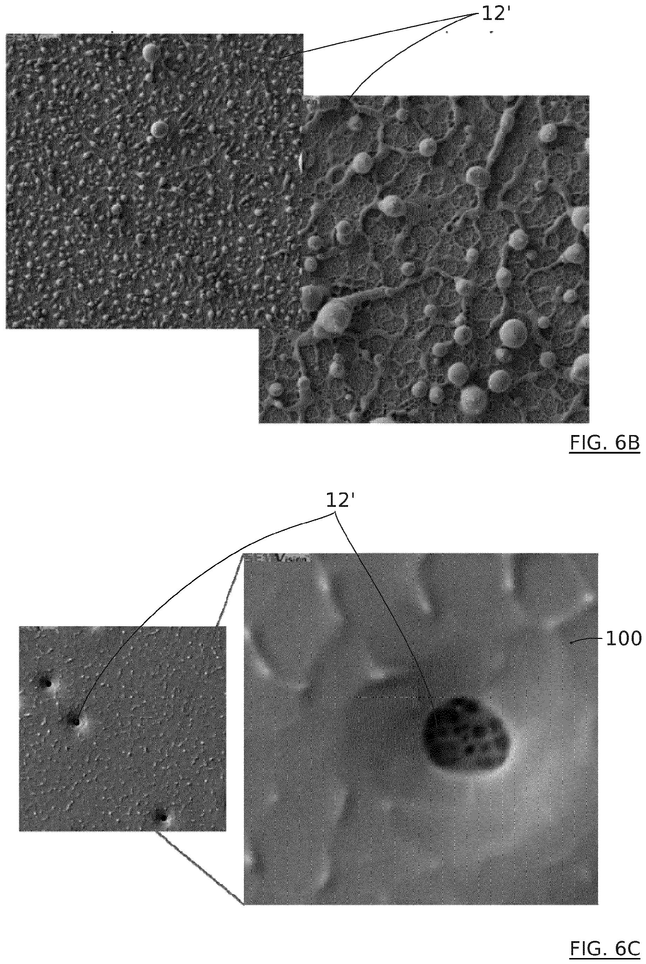

Selon un deuxième exemple, une portion poreuse 12' différente est obtenue pour une implantation d'ions d'hélium à 52 keV, à une dose de 4.10¹⁴ ions/cm², suivie d'un recuit par laser avec une durée d'impulsion de 160 ns, à une fluence F = 3,2 J/cm², est illustrée en figure 6B.

Selon un troisième exemple, illustré en figure 6C, on peut observer que pour certaines conditions du procédé, et notamment pour une fluence F trop faible du recuit par laser, la surface 100 de la couche 10 n'est pas texturée. Une portion poreuse 12' enterrée est alors formée, c'est à dire qu'on forme une portion poreuse 12' à porosité fermée, par exemple après une implantation d'ions d'hélium à 52 keV, à une dose de 15.10¹⁵ ions/cm², suivie d'un recuit par laser avec une durée d'impulsion de 160 ns, à une fluence F = 2,5 J/cm². On peut prévoir qu'un deuxième recuit par laser puisse être effectué ensuite, par exemple à une fluence supérieure, pour obtenir la portion poreuse 12'.

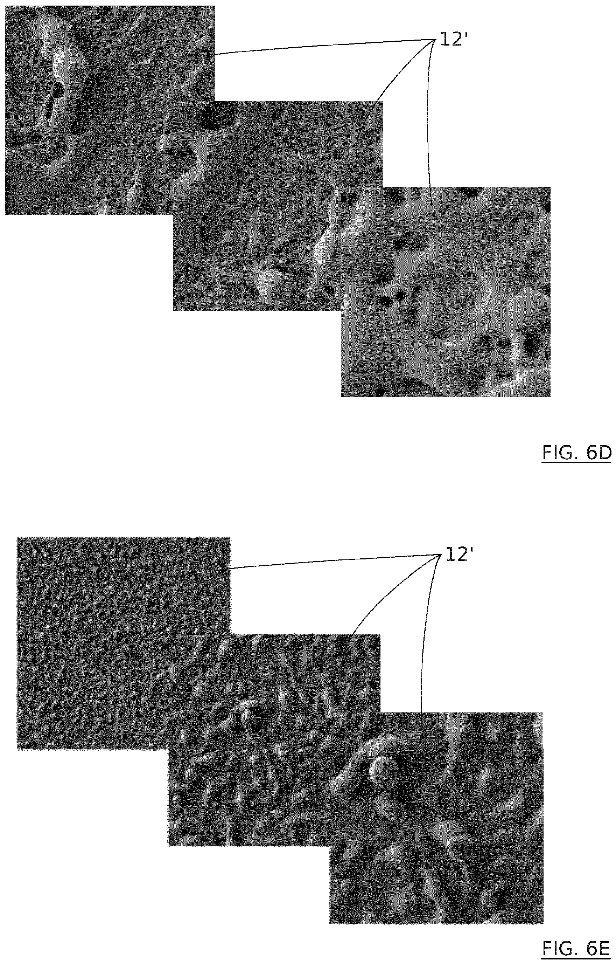

Selon un quatrième exemple, la portion poreuse 12' obtenue après une implantation d'ions d'hélium à une énergie comprise entre 30 et 40 keV, à une dose de 4.10¹⁶ ions/cm², suivie d'un recuit par laser avec une durée d'impulsion de 160 ns, à une fluence F = 3 J/cm², est illustrée en figure 6D.

Selon un cinquième exemple, la portion poreuse 12' obtenue après une implantation d'ions d'hélium à une énergie comprise entre 30 et 40 keV, à une dose de 4.10¹⁶ ions/cm², suivie d'un recuit par laser avec une durée d'impulsion de 160 ns, à une fluence F = 3,1 J/cm², est illustrée en figure 6E.

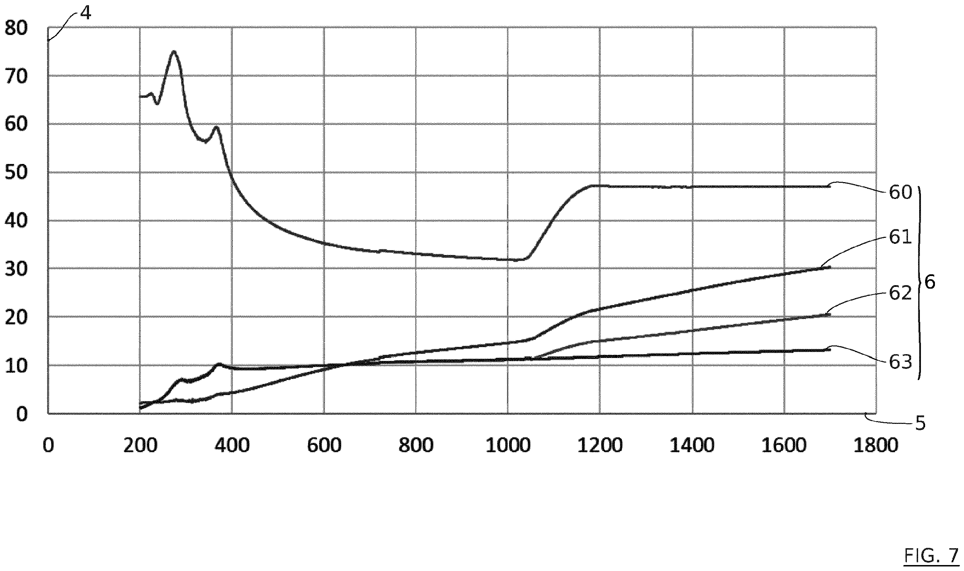

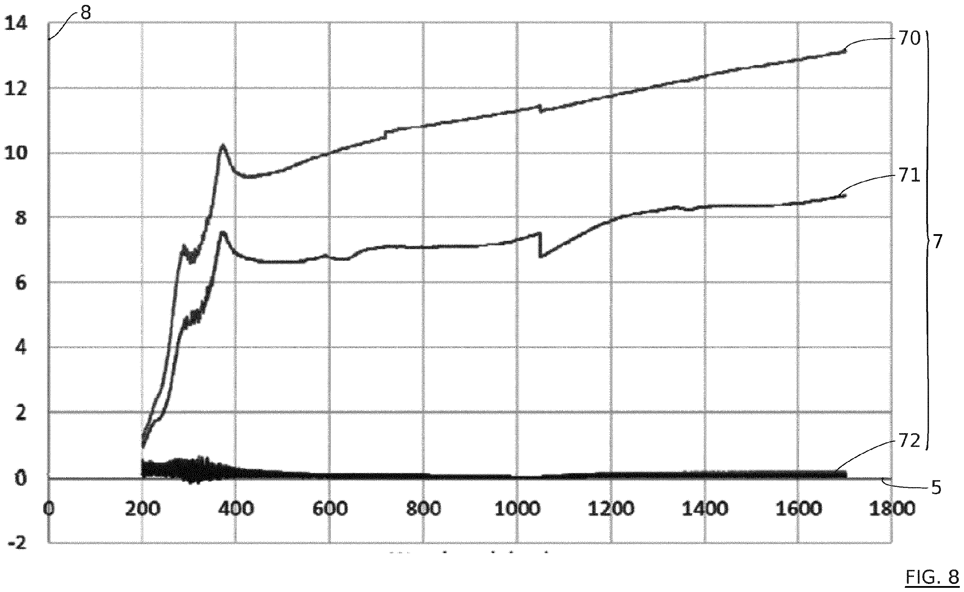

Les propriétés de réflectivités pour différents substrats de référence, et différentes portions poreuses 12' obtenues selon plusieurs modes de réalisation particuliers de l'invention sont maintenant illustrées en référence aux figures 7 et 8. La figure 7 représente un graphique de la réflectivité à un angle d'incidence de 7°, en fonction de la longueur d'onde de la lumière incidente, mesurée pour :
- une couche superficielle de silicium 60,
- une couche superficielle de silicium implantée après recuit par laser (F = 3,3 J/cm²) 61,
- une couche superficielle de silicium implantée après recuit par laser (F = 3,15 J/cm²) 62,
- une couche superficielle de silicium implantée après recuit par laser (F = 3,15 J/cm²) 63, dans cet échantillon la surface en face arrière du substrat a été rugosifiée pour éviter des réflexions parasites venant de la face arrière.

Les couches superficielles de silicium implantée et ayant subi un recuit par laser, correspondant aux couches 62 à 65, présentent les réflectivités les plus faibles, ces réflectivités étant significativement inférieure à une couche superficielle de silicium 60 de référence. Pour la couche 62, une fluence de recuit de 3,3 J/cm² permet d'obtenir les plus basses valeurs de réflectivité dans le domaine du visible. Pour un spectre de longueurs d'onde de 200 à 1800 nm, il semble toutefois qu'une fluence de 3,15 J/cm² permette d'obtenir des valeurs de réflectivité inférieures au-delà de 650 nm.

Cette diminution de la réflectivité observée sur les différentes portions poreuses 12' obtenues selon plusieurs modes de réalisation particuliers de l'invention, peut notamment s'expliquer par la large gamme de diamètre de pores de chaque portion poreuse 12'. Chaque portion poreuse 12' peut ainsi interagir avec une gamme étendue de longueur d'onde, ce qui induit une diminution de la réflectivité.

La figure 8 représente un graphique de la réflectivité mesurée selon plusieurs angles d'incidence, pour la couche superficielle de silicium implantée après recuit par laser (F = 3,15 J/cm²), et rugosifié en face arrière pour éviter des réflexions parasites 65, à :
- un angle d'incidence de 7° pour la courbe 70,
- un angle d'incidence de 12° pour la courbe 71,
- des angles d'incidence compris entre 17° à 62° pour les courbes 72.

Pour un angle d'incidence supérieur à 12°, la réflectivité de la couche 65 est environ nulle, ce qui valide bien le potentiel du procédé pour l'obtention de silicium noir, par exemple pour des applications dans le photovoltaïque.

Au vu de la description qui précède, il apparaît clairement que l'invention propose un procédé amélioré de formation d'une portion poreuse à base d'un matériau semi-conducteur. Notamment, le procédé étant compatible avec différents matériaux semi-conducteurs, différents ions implantés, et présentant de nombreux paramètres pouvant être modulés, le procédé permet d'obtenir des portions poreuses à base d'un matériau semi-conducteur, présentant des structures diverses. Le procédé permet de moduler la structure et les propriétés de la portion poreuse à base du semi-conducteur.

L'invention n'est pas limitée aux modes de réalisations précédemment décrits et s'étend à tous les modes de réalisation couverts par les revendications.

### LISTE DES REFERENCES

1 Substrat
10 Couche à base d'un matériau semi-conducteur
100 Surface
101 Fraction
11 Zone implantée
11a Première zone implantée
11b Deuxième zone implantée
110 Microstructure
110a Première microstructure
110b Deuxième microstructure
12 Portion
12a Première portion
12b Deuxième portion
12' Portion poreuse
13 Masque
2 Bruit de fond diffus (H, de l'anglais *Haze*)
20 Régime de basse fluence
21 Régime intermédiaire
22 Régime de haute fluence
3 Fluence (F, en J/cm²)
4 Réflectivité à un angle d'incidence de 7° (en %)
5 Longueur d'onde (en nm)
6 Courbes de la réflectivité à 7° d'incidence, pour
60 Une couche superficielle de silicium
61 Une couche superficielle de silicium implantée après recuit par laser (F = 3,3 J/cm²)
62 Une couche superficielle de silicium implantée après recuit par laser (F = 3,15 J/cm²)
63 Une couche superficielle de silicium implantée après recuit par laser (F = 3,15 J/cm²), dont la surface en face arrière du substrat a été rugosifiée
7 Courbes de la réflectivité à d d'incidence pour une couche superficielle de silicium implantée après recuit par laser (F = 3,15 J/cm²), à
70 Un angle d'incidence de 7°
71 Un angle d'incidence de 12°
72 Des angles d'incidence compris entre 17° à 62°
E₁ Première épaisseur
E₂ Deuxième épaisseur
P Profondeur d'implantation
P₁ Première profondeur d'implantation
P₂ Deuxième profondeur d'implantation

## Revendications

1. Procédé de formation d'une portion poreuse (12') dans un substrat (1), le procédé comprenant :
• une fourniture d'un substrat (1) comprenant une couche (10),
• une implantation d'ions choisis parmi des ions d'hydrogène et de gaz noble dans au moins une zone (11) de la couche (10), la zone (11) implantée étant située à une profondeur d'implantation (P) dans la couche (10), de façon à former une portion enrichie(110) en au moins un gaz dans la zone (11) implantée, puis
• un recuit par laser de type nanoseconde de façon à induire, à partir de la zone implantée (11), au moins l'un parmi la formation et le développement d'une portion poreuse (12') à la surface du substrat (1), la portion poreuse (12') comprenant des pores présentant une surface interne,
• un traitement de surface de la portion poreuse (12') comprenant une oxydation thermique de la surface interne des pores de la portion poreuse (12') ou un dépôt d'un matériau diélectrique ou d'un matériau semi-conducteur, sur ladite surface interne.

2. Procédé selon la revendication précédente, dans lequel, lors de l'implantation d'ions, un mélange d'ions d'éléments chimiques distincts est implanté de façon à former une portion enrichie en une pluralité de gaz.

3. Procédé selon l'une quelconque des revendications précédentes, dans lequel, lors de l'implantation d'ions, les ions sont choisis parmi des ions d'hydrogène et des ions de gaz noble, les ions de gaz noble étant choisis parmi les ions de l'hélium, du néon, de l'argon et du xénon.

4. Procédé selon l'une quelconque des revendications précédentes, dans lequel l'implantation d'ions est réalisée à une température comprise entre -200°C et 1200°C, de préférence entre 20 °C et 450 °C.

5. Procédé selon l'une quelconque des revendications précédentes, le procédé comprenant en outre un recuit thermique entre l'implantation d'ions et le recuit par laser, de préférence le recuit thermique est réalisé à une température supérieure à une température de l'implantation d'ions, plus préférentiellement encore la température du recuit thermique est comprise entre 200°C et 1200°C, de préférence entre 350°C et 1100°C.

6. Procédé selon l'une quelconque des revendications précédentes, le procédé comprenant en outre l'application d'un masque (13) sur une fraction (101) d'une surface (100) exposée du substrat (1) préalablement à l'implantation d'ions, et un retrait du masque (13) après l'implantation d'ions, et de préférence entre l'implantation d'ions et le recuit par laser.

7. Procédé selon l'une quelconque des revendications précédentes, dans lequel, le procédé comprend plusieurs implantations d'ions, de préférence successives.

8. Procédé selon la revendication précédente dans lequel les éléments chimiques des ions et/ou les proportions relatives entre des ions d'éléments chimiques distincts varient entre les différentes implantations d'ions.

9. Procédé selon l'une quelconque des revendications 7 et 8, dans lequel au moins une parmi les plusieurs implantations d'ions est réalisée à une profondeur d'implantation différente par rapport aux profondeurs d'implantation des autres implantations d'ions.

10. Procédé selon l'une quelconque des revendications 7 à 9, dans lequel au moins une parmi les plusieurs implantations d'ions est configurée pour implanter une dose différente par rapport aux doses implantées des autres implantations d'ions.

11. Procédé selon l'une quelconque des revendications précédentes, dans lequel le recuit par laser de type nanoseconde est mis en œuvre à une densité d'énergie prédéterminée, la densité d'énergie prédéterminée étant choisie à l'aide d'une courbe représentant, en fonction de la densité d'énergie, un signal proportionnel à une rugosité, la courbe présentant au moins une augmentation dudit signal pour une gamme de densité d'énergie, la densité d'énergie prédéterminée étant choisie dans cette gamme.

12. Procédé selon l'une quelconque des revendications précédentes, dans lequel la couche (10) est à base d'un matériau semi-conducteur, de préférence le matériau semi-conducteur est cristallin, voire monocristallin.

13. Procédé selon la revendication précédente, dans lequel le matériau semi-conducteur est à base de silicium monocristallin.

14. Composant microélectronique obtenu par le procédé selon l'une quelconque des revendications précédentes, comprenant :
• un substrat (1) comprenant une couche (10),
• une portion poreuse (12'), formée par recuit par laser de type nanoseconde, à partir d'une portion enrichie (110) en au moins un gaz d'une zone (11) implantée, située à une profondeur d'implantation (P) de la couche (10),
dans lequel la couche (10) est à base d'un matériau semi-conducteur monocristallin et la portion poreuse (12') présente une porosité ouverte, et
dans lequel la portion poreuse (12') comprend des pores présentant une surface interne, la surface interne étant oxydée ou une couche d'un matériau diélectrique ou d'un matériau semi-conducteur étant déposée sur la surface interne.

## Patentansprüche

1. Verfahren zur Herstellung eines porösen Teils (12') in einem Substrat (1), wobei das Verfahren umfasst:
- eine Bereitstellung eines Substrat (1), umfassend eine Schicht (10),
- eine Implantation von Ionen, ausgewählt aus Wasserstoff- und Edelgasionen, in mindestens eine Zone (11) der Schicht (10), wobei die implantierte Zone (11) sich in einer Implantationstiefe (P) in der Schicht (10) befindet, um einen mit mindestens einem Gas angereicherten Teil (110) in der implantierten Zone (11) zu bilden, dann
- ein Laserglühen vom Nanosekundentyp, um von der implantierten Zone (11) mindestens eine von der Bildung und der Entwicklung eines porösen Teils (12') auf der Oberfläche des Substrats (1) zu induzieren, wobei der poröse Teil (12') Poren umfasst, die eine innere Oberfläche aufweisen,
- eine Behandlung einer Oberfläche des porösen Teils (12'), umfassend eine thermische Oxidation der inneren Oberfläche von Poren des porösen Teils (12') oder eine Abscheidung eines dielektrischen Materials oder eines Halbleitermaterials auf der inneren Oberfläche.

2. Verfahren nach dem vorhergehenden Anspruch, wobei während der Implantation von Ionen ein Gemisch von Ionen von verschiedenen chemischen Elementen implantiert wird, um einen mit einer Vielzahl von Gasen angereicherten Teil zu bilden.

3. Verfahren nach einem der vorhergehenden Ansprüche, wobei während der Implantation von Ionen die Ionen aus Wasserstoffionen und Edelgasionen ausgewählt werden, wobei die Edelgasionen aus Helium-, Neon-, Argon- und Xenonionen ausgewählt sind.

4. Verfahren nach einem der vorhergehenden Ansprüche, wobei die Implantation von Ionen bei einer Temperatur durchgeführt wird, die zwischen -200°C und 1200°C, vorzugsweise zwischen 20°C und 450°C liegt.

5. Verfahren nach einem der vorhergehenden Ansprüche, wobei das Verfahren weiterhin ein thermisches Glühen zwischen der Implantation von Ionen und dem Laserglühen umfasst, wobei vorzugsweise das thermische Glühen bei einer Temperatur durchgeführt wird, die höher als eine Temperatur der Implantation von Ionen ist, wobei noch mehr bevorzugt die Temperatur des thermischen Glühens zwischen 200°C und 1200°C, vorzugsweise zwischen 350°C und 1100°C liegt.

6. Verfahren nach einem der vorhergehenden Ansprüche, wobei das Verfahren weiterhin das Aufbringen einer Maske (13) auf einem Anteil (101) einer freigelegten Oberfläche (100) des Substrats (1) vor der Implantation von Ionen und eine Entfernung der Maske (13) nach der Implantation von Ionen und vorzugsweise zwischen der Implantation von Ionen und dem Laserglühen umfasst.

7. Verfahren nach einem der vorhergehenden Ansprüche, wobei das Verfahren mehrere Implantationen von Ionen, vorzugsweise aufeinanderfolgend, umfasst.

8. Verfahren nach dem vorhergehenden Anspruch, wobei die chemischen Elemente von Ionen und/oder die relativen Verhältnisse zwischen Ionen von verschiedenen chemischen Elementen zwischen den unterschiedlichen Implantationen von Ionen variieren.

9. Verfahren nach einem der Ansprüche 7 und 8, wobei mindestens eine von den mehreren Implantationen von Ionen mit einer Implantationstiefe durchgeführt wird, die sich in Bezug auf die Implantationstiefen von den anderen Implantationen von Ionen unterscheidet.

10. Verfahren nach einem der Ansprüche 7 bis 9, wobei mindestens eine von den mehreren Implantationen von Ionen dazu konfiguriert ist, eine Dosis zu implantieren, die sich in Bezug auf die implantierten Dosen von den anderen Implantationen von Ionen unterscheidet.

11. Verfahren nach einem der vorhergehenden Ansprüche, wobei das Laserglühen vom Nanosekundentyp mit einer vorherbestimmten Energiedichte ausgeführt wird, wobei die vorherbestimmte Energiedichte mittels einer Kurve gewählt wird, die in Abhängigkeit von der Energiedichte ein Signal darstellt, das proportional zu einer Rauheit ist, wobei die Kurve mindestens eine Verstärkung des Signals für einen Energiedichtebereich aufweist, wobei die vorherbestimmte Energiedichte aus diesem Bereich ausgewählt wird.

12. Verfahren nach einem der vorhergehenden Ansprüche, wobei die Schicht (10) auf einem Halbleitermaterial basiert, wobei vorzugsweise das Halbleitermaterial kristallin, sogar monokristallin ist.

13. Verfahren nach dem vorhergehenden Anspruch, wobei das Halbleitermaterial auf monokristallinem Silicium basiert.

14. Mikroelektronische Komponente, die durch das Verfahren nach einem der vorhergehenden Ansprüche erhalten wird, umfassend:
- ein Substrat (1), umfassend eine Schicht (10),
- einen porösen Teil (12'), der durch Laserglühen vom Nanosekundentyp aus einem mit mindestens einem Gas angereicherten Teil (110) einer implantierten Zone (11) gebildet wird, die sich in einer Implantationstiefe (P) der Schicht (10) befindet,
wobei die Schicht (10) auf einem monokristallinen Halbleitermaterial basiert und der poröse Teil (12') eine offene Porosität aufweist, und
wobei der poröse Teil (12') Poren aufweist, die eine innere Oberfläche umfassen,
wobei die innere Oberfläche oxidiert ist oder eine Schicht eines dielektrischen Materials oder eines Halbleitermaterials auf der inneren Oberfläche abgeschieden ist.

## Claims

1. Method for forming a porous portion (12') in a substrate (1), the method comprising:
- providing a substrate (1) comprising a layer (10),
- implanting ions selected from hydrogen ions and noble gas ions into at least one region (11) of the layer (10), the implanted region (11) being located at an implantation depth (P) in the layer (10), so as to form an enriched portion (110) enriched with at least one gas in the implanted region (11), then
- laser annealing of the nanosecond type so as to induce, from the implanted region (11), at least one from among the formation and the development of a porous portion (12') at the surface of the substrate (1), the porous portion (12') comprising pores having an inner surface,
- surface treating the porous portion (12') comprising thermal oxidation of the inner surface of the pores of the porous portion (12') or deposition of a dielectric material or of a semiconductor material on said inner surface.

2. Method according to the preceding claim wherein, during ion implantation, a mixture of ions of different chemical elements is implanted so as to form a portion enriched with a plurality of gases.

3. Method according to any one of the preceding claims wherein, during ion implantation, the ions are selected from hydrogen ions and noble gas ions, the noble gas ions being selected from helium, neon, argon and xenon ions.

4. Method according to any one of the preceding claims, wherein the ion implantation is carried out at a temperature comprised between -200°C and 1,200°C, preferably between 20°C and 450°C.

5. Method according to any one of the preceding claims, the method further comprising thermal annealing between the ion implantation and the laser annealing, preferably thermal annealing is carried out at a temperature that is higher than a temperature of the ion implantation, more preferably the temperature of the thermal annealing is comprised between 200°C and 1,200°C, preferably between 350°C and 1,100°C.

6. Method according to any one of the preceding claims, the method further comprising applying a mask (13) to a fraction (101) of an exposed surface (100) of the substrate (1) prior to ion implantation, and removing the mask (13) after ion implantation, and preferably between the ion implantation and the laser annealing.

7. Method according to any one of the preceding claims, wherein the method comprises a plurality of preferably successive ion implantations.

8. Method according to the preceding claim, wherein the chemical elements of the ions and/or the relative proportions between ions of different chemical elements vary between the different ion implantations.

9. Method according to any one of claims 7 and 8, wherein at least one of the plurality of ion implantations is carried out at a different implantation depth from the implantation depths of the other ion implantations.

10. Method according to any one of claims 7 to 9, wherein at least one of the plurality of ion implantations is configured to implant a different dose from the doses implanted during the other ion implantations.

11. Method according to any one of the preceding claims, wherein the laser annealing of the nanosecond type is implemented at a predetermined energy density, the predetermined energy density being selected by means of a curve representing, as a function of the energy density, a signal proportional to a roughness, the curve showing at least an increase in said signal for an energy density range, the predetermined energy density being selected within this range.

12. Method according to any one of the preceding claims, wherein the layer (10) is semiconductor material-based, preferably the semiconductor material is crystalline or monocrystalline.

13. Method according to the preceding claim, wherein the semiconductor material is monocrystalline silicon-based.

14. Microelectronic component obtained by the method according to any one of the preceding claims, comprising:
- a substrate (1) comprising a layer (10),
- a porous portion (12'), formed by laser annealing of the nanosecond type, from an enriched portion (110) enriched with at least one gas of an implanted region (11), located at an implantation depth (P) in the layer (10),
wherein the layer (10) is monocrystalline semiconductor material-based and the porous portion (12') has an open porosity, and
wherein the porous portion (12') comprises pores having an inner surface, the inner surface being oxidised or a layer of a dielectric material or of a semiconductor material being deposited on the inner surface.
